(19) Europäisches Patentamt
European Patent Office
Office européen des brevets

(11) **EP 1 394 932 B1**

(12) **EUROPEAN PATENT SPECIFICATION**

(45) Date of publication and mention
of the grant of the patent:
**14.02.2007 Bulletin 2007/07**

(51) Int Cl.:
***H03F 1/07*** (2006.01)

(21) Application number: **03101651.2**

(22) Date of filing: **05.06.2003**

(54) **Doherty Amplifier**

Doherty Verstärker

Amplificateur de type Doherty

(84) Designated Contracting States:
**FI GB SE**

(30) Priority: **29.08.2002 KR 2002051501**

(43) Date of publication of application:
**03.03.2004 Bulletin 2004/10**

(73) Proprietor: **Postech Foundation**
**,**
**Pohang-City, Kyungsangbuk-do (KR)**

(72) Inventors:
• **Kim, Bumman**
**Pohang-city, Kyungsangbuk-do (KR)**
• **Yang, Youngoo**
**Pohang Univ.of Science&Techn. Found.**
**Pohang-city, Kyungsangbuk-do (KR)**
• **Cha, Jeonghyeon**
**Pohang Univ.of Science&Techn. F.**
**Pohang-city, Kyungsangbuk-do (KR)**

(74) Representative: **Stanley, David William**
**Stanleys**
**Intellectual Property**
**Kings Court**
**12 King Street**
**Leeds LS1 2HL (GB)**

(56) References cited:
**EP-A- 0 630 104**     **US-A- 5 025 225**
**US-A- 5 757 229**     **US-A- 6 097 252**
**US-B1- 6 262 629**     **US-B1- 6 356 149**

EP 1 394 932 B1

**Description**

The present invention relates to microwave Doherty amplifiers.

As is well-known to those skilled in the art, a Doherty amplifier is a type of amplifier used in high efficiency modulation of a power transmitter, and improves efficiency by combining a class B amplifier, a class C amplifier, and an impedance inverse circuit. The Doherty amplifier employs a method connecting a carrier amplifier and a peak amplifier (or a peaking amplifier) in parallel by using a quarter wave transformer ($\lambda$/4 line).

The peak amplifier (or peaking amplifier) of the Doherty amplifier controls the load impedance of the carrier amplifier by changing the amount of current provided to a load according to power level so that efficiency improves.

The microwave Doherty amplifier was introduced by W. H. Doherty in 1936 and, in its initial stages, was used in an amplitude modulation (AM) transmitter of a broadcasting apparatus using a long frequency (LF) vacuum tube and a medium frequency (MF) vacuum tube.

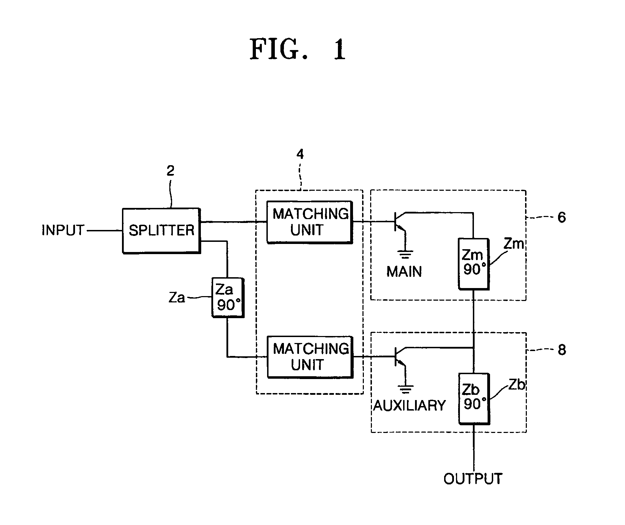

Since the microwave Doherty amplifier was first applied to and used in the AM transmitter, a variety of suggestions for using the microwave Doherty amplifier in a solid-state high output power transmitter have been made and many methods for actual implementation have been proposed. One of the methods is shown in Figure 1, in which impedance is transformed by using quarter wave transformers 6 and 8 having characteristic impedances (Zm, Zb). In this method, only resistive matching by a matching unit 4 is possible. Reference number 2 indicates a splitter for distribution of the input. Za is a characteristic impedance of the line such that the two outputs of the splitter 2 have a phase difference of 90°.

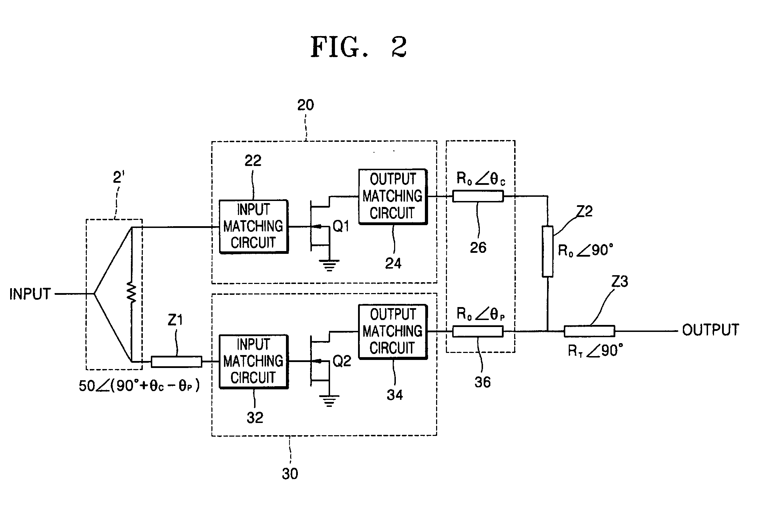

The method shown in Figure 2 is another embodiment of the prior art in which the microwave Doherty amplifier is applied to a solid-state high output power transmitter. By placing matching circuits 24 and 34 at the output parts of transistors (Q1, Q2) and placing offset lines 26 and 36 after the matching circuits 24 and 34, this method enables matching of the imaginary part as well as the real part of the impedances so that the output power of the amplifier is maximized and a Doherty operation is performed. Reference number 2' indicates a splitter, reference number 20 indicates a carrier amplifying unit, reference number 30 indicates a peak amplifying unit and Z1, Z2, and Z3 are characteristic impedances, respectively, of lines having the phase angles shown in Figure 2.

However, although a Doherty amplifier increases efficiency when used in a high output power amplifier, it tends to have insufficient improvement of linearity, which is needed for high capability and functionality of an apparatus.

US 5 025 225 discloses a multi(N)-stage Doherty amplifier in which each stage is of similar configuration, having a transmission line section at its input and a quarter-wavelength transmission line section at its output, which is connected to the corresponding point of the succeeding stage by a further quarter-wavelength transmission line section. The transmission lines at the inputs of each of the stages introduce path length delays that increase successively by 90°.

US 5 757 229 discloses a Doherty amplifier that utilises envelope detection to derive signals for controlling amplifier gain.

EP 0 630 104 discloses a 2-stage (1:1) Doherty amplifier having a single carrier amplifier and a single peak amplifier, having the same power capabilities.

Preferred embodiments of the present invention aim to provide a Doherty amplifier which employs a way-extension method by which N ways (N $\geq$ 3, N is a natural number) are established, and an envelope tracking method so that when the Doherty amplifier is applied to the power amplifier of a mobile communications base station or a handset, high efficiency and linearity can be simultaneously achieved and price competitiveness and reliability of an apparatus employing the Doherty amplifier can be improved.

It is another aim to provide a Doherty amplifier which, in order to obtain improved efficiency characteristics in all types of Doherty amplifiers, extracts a predetermined input envelope signal, appropriately shapes the signal, and provides the signal to the gate bias of a peak amplifier.

According to one aspect of the present invention, there is provided a Doherty amplifier comprising:

N ways, where N $\geq$ 3 and N is a natural number;

a power distribution unit which distributes power to each of the N ways;

a carrier amplifier placed on one of the N ways; and

a respective peak amplifier placed on each of the remaining (N-1) ways, excluding the way on which the carrier amplifier is placed:

wherein the carrier amplifier and peak amplifier(s) are formed using identical transistors and all of the N ways meet at a common point to which a quarter wave impedance transformer is connected downstream of the N ways.

Preferably, the characteristic impedance ($R_T$) of the quarter wave impedance transformer is:

$$R_T = \sqrt{\frac{R_{OP}R_{OC}}{R_{OP}}}R_O$$

where $R_O$ is an output load resistance at the back of the quarter wave impedance transformer, $R_{OC}$ is a characteristic impedance of an offset line at the back of the carrier amplifier and $R_{OP}$ is a characteristic impedance of an offset line at the back of the or each peak amplifier.

Preferably, a quarter-wave transmission line is provided at the back of the carrier amplifier, the characteristic impedance of an offset line at the back of the carrier amplifier has a predetermined angle of $\theta_C$, the characteristic impedance of an offset line at the back of the peak amplifier has a predetermined angle of $\theta_P$ and a transmission line having a predetermined angle of $90° + \theta_C - \theta_P$ is placed in front of the or each peak amplifier.

Preferably, a Doherty amplifier as above further comprises an envelope tracking unit which turns off the peak amplifier in a low power range and gradually turns on the or each peak amplifier to the level of the carrier amplifier bias in a high power range, in order to use the characteristic of the Doherty amplifier which makes the gate bias of the carrier amplifier different from the gate bias of the or each peak amplifier.

Preferably, the envelope tracking unit comprises:

an envelope detector; and
an envelope shaping circuit which attenuates and/or amplifies an envelope signal detected by the envelope detector, removes an offset, and provides the signal as a gate voltage of the or each peak amplifier.

The invention extends to a communications base station comprising a Doherty amplifier according to any of the preceding aspects of the invention.

For a better understanding of the invention, and to show how embodiments of the same may be carried into effect, reference will now be made, by way of example, to the accompanying diagrammatic drawings, in which:

Figure 1 is a diagram of the structure of an embodiment of a microwave Doherty amplifier according to the prior art;

Figure 2 is a diagram of the structure of another embodiment of a microwave Doherty amplifier according to the prior art;

Figure 3 is a diagram of the structure of one example of a microwave Doherty amplifier according to a preferred embodiment of the present invention;

Figure 4 is a graph to explain linearization of the Doherty amplifier of Figure 3;

Figure 5 is a diagram of the structure of a Doherty amplifier employing an envelope tracking apparatus according to an example of the present invention;

Figure 6a is a diagram of the structure of an embodiment of an envelope shaping circuit of the envelope tracking apparatus of Figure 5;

Figure 6b is a graph of a transfer curve of a signal passing through the envelope shaping circuit of Figure 6a;

Figure 7a is a graph showing spectrums resulting from linearization experiments when the number of ways is 3 (N=3) in Figure 3; and

Figure 7b is a graph showing the efficiency which can be obtained by a Doherty amplifier having 2 ways (N=2) and employing the envelope tracking apparatus of Figure 5, as compared with the efficiency of an ordinary class AB amplifier.

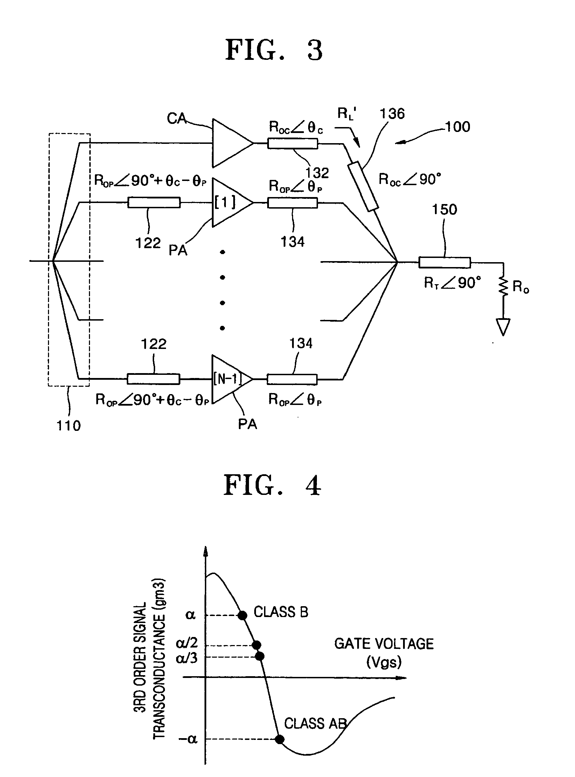

Figure 3 shows a microwave Doherty amplifier (N-way Doherty amplifier) 100 according to one embodiment of the present invention, which is extended to have N ways ($N \geq 3$, N is a natural number). The Doherty amplifier 100 according to this embodiment includes a carrier amplifier (CA) located at the top and N-1 peak amplifiers (PA) located under the carrier amplifier (CA). Therefore, the Doherty amplifier according to this embodiment has N ways in total and has a splitter 110 which distributes appropriate power to each of the ways. The splitter 110 is placed at the front of the N-ways as shown in Figure 3. The carrier amplifier (CA) and peak amplifiers (PA[1] through PA[N-1]) can be implemented using identical transistors. When identical transistors are used to implement the carrier amplifier (CA) and peak amplifiers (PA), respective characteristic impedances can be determined such that perfect power combining can be achieved. For this, in the Doherty amplifier 100 of this embodiment, a quarter wave impedance transformer 150 located in front of an output load resistance ($R_O$) has the same impedance ($R_T$) as presented in expression 1:

$$R_T = \sqrt{\frac{R_{OP} R_{OC}}{R_{OP}}} \, R_O \quad \ldots \ldots (1)$$

where $R_{OC}$ is a characteristic impedance of an offset line 132 located at the back of the carrier amplifier (CA) and $R_{OP}$ is a characteristic impedance of an offset line 134 located at the back of each peak amplifier (PA).

Meanwhile, in the Doherty amplifier 100 of the present embodiment, the offset line 132 located at the output of the carrier amplifier (CA) has an angle of $\theta_C$ and the offset line 134 located at the output of each peak amplifier (PA) has an angle of $\theta_P$, as shown in Figure 3. In order to compensate for the effect of the quarter-wave transmission line 136 at the end of the carrier amplifier for Doherty operation and the offset lines 132 and 134, a transmission line 122 having a predetermined angle of $90° + \theta_C - \theta_P$ is placed at the input of each peak amplifier (PA).

Figure 4 is a graph to explain the linearization principle of the Doherty amplifier according to the present embodiment. Figure 4 shows the third order large signal transconductance (gm3) versus gate voltage. Transconductance has a nonlinear characteristic and this can be expanded with a number of terms, in which the number of terms is determined according to the size of the signal. It is well-known that at this time, a first order term is a component for normal amplification, and an n-th order term is a component for generating an n-th order harmonic wave.

In the case of an ordinary field effect transistor (FET), the third order large signal transconductance (gm3) is transited from a positive value to a negative value according to the gate voltage (Vgs). In the case of an ordinary normal class AB bias (-$\alpha$ location of Figure 4), the third transconductance (gm3) is negative, and in an appropriate location near class B, a location having a value $\alpha$ can be found. Therefore, if two amplifiers combined in parallel have different biases, third order intermodulation (IM3) components having phases opposite to each other are generated and a cancellation effect is eventually obtained in the final output. Here, in the case of a Doherty amplifier having N ways, if the carrier amplifier is biased at -$\alpha$ location and the bias of (N-1) peak amplifiers (PA) is adjusted as $\alpha$ /(N-1), the third order intermodulation (IM3) component, which is a third harmonic wave generated by non-linearity, can be accurately cancelled.

Generally, in the case of a Doherty amplifier in which N=2, in order to completely cancel the IM3 component, the peak amplifier should be biased at $\alpha$. However, at this time, bias of the peak amplifier is too low such that significant fifth or higher order intermodulation distortion can occur. That is, obtaining optimal linearity improvement may cause a large high order intermodulation distortion. Therefore, as in the present embodiment, the occurrence of high order intermodulation distortion in obtaining optimal linearity improvement should be prevented. Accordingly, there is a need for extension of ways (N $\geq$ 3), and as the number of peak amplifiers (PA) increases, cancellation of the third order intermodulation component is enabled in conditions of relatively high bias.

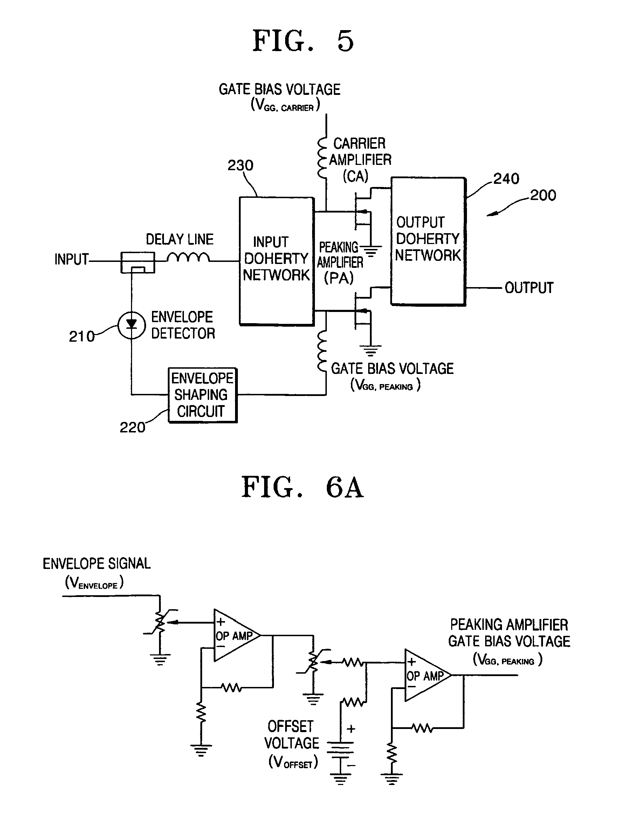

Figure 5 is a diagram of the structure of a Doherty amplifier employing an envelope tracking apparatus 200 according to an embodiment of the present invention. The major characteristic of the envelope tracking apparatus 200 according to this embodiment is use of the characteristic of a Doherty amplifier to make the gate bias voltage of the carrier amplifier (CA) and the gate bias voltage of the peak amplifier (PA) different.

The envelope tracking apparatus 200 of the present embodiment uses an envelope tracking method for adjusting the peak amplifier (PA), by which the peak amplifier (PA) is turned off in a low power range, and in a high power range, is gradually turned on to the level of the gate bias voltage ($V_{GG, Carrier}$) of the carrier amplifier (CA). By doing so, the envelope tracking apparatus 200 according to this embodiment becomes appropriate for amplification of a modulated signal, which envelope changes with respect to time, and prevents in advance gain decrease, output power decrease, and degradation of linearity that may occur by fixing the gate bias voltage ($V_{GG, Peaking}$) of the carrier amplifier (CA) to a low value. It will be clear to those skilled in the art that the Doherty amplifier having N ways as shown in Figure 3, as well as all existing Doherty amplifiers, can be applied to the envelope tracking apparatus 200 according to this embodiment.

Reference number 210 in Figure 5 indicates an envelope detector for detecting an envelope, and 220 indicates an envelope shaping circuit for appropriately transforming an envelope signal detected by the envelope detector 210. Reference number 230 indicates an input Doherty network, reference number 240 indicates an output Doherty network, and a carrier amplifier (CA) and a peak amplifier (PA) are located between the input Doherty network 230 and the output Doherty network 240.

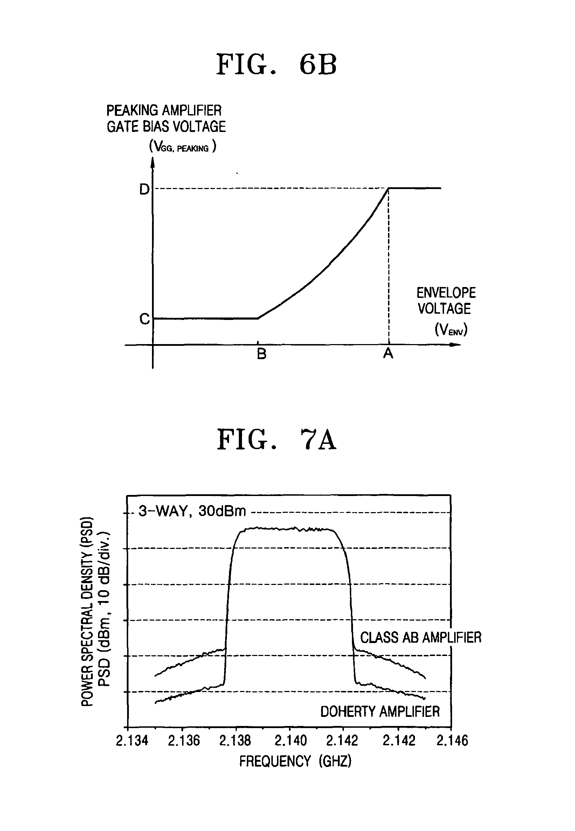

Figure 6a is a diagram of the structure of an embodiment of an envelope shaping circuit 220 of the envelope tracking apparatus 200 of Figure 5. By appropriately attenuating and amplifying a low frequency envelope signal detected by the envelope detector 210, and subtracting an offset from the signal, the envelope shaping circuit 220 makes the changes in the output voltage according to the envelope voltage ($V_{ENV}$) as shown in Figure 6b, and provides the voltage to the peak amplifier (PA) as the gate bias voltage ($V_{GG, Peaking}$).

In Figure 6b, location A indicates a location showing a maximum envelope voltage, and location B indicates a location where the peak amplifier (PA) of the Doherty amplifier 100 is turned on. Normally when N=2, location B indicates a location of 6dB backed-off power from peak output power. In the region less than B, the gate bias voltage ($V_{GG, Peaking}$) of the peak amplifier (PA) is C, which should almost completely turn off the peak amplifier (PA). In location A, the gate bias voltage ($V_{GG, Peaking}$) of the peak amplifier (PA) is D and the bias of the peak amplifier (PA) is made to be the same as the gate bias voltage ($V_{GG, Carrier}$) of the carrier amplifier (CA). Figure 6b is a graph related to the envelope shaping circuit 220, and by making a variety of changes to the Doherty amplifier by applying this graph, the linearity and efficiency of the Doherty amplifier can be optimized.

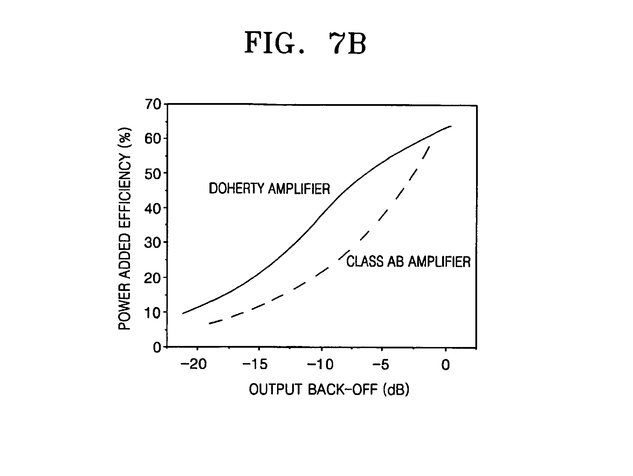

Figure 7a is a graph showing spectrums obtained by measuring in a 21.4GHz band for the Doherty amplifier with N=3 as a preferred embodiment of the present invention. Referring to Figure 7a, the graph shows that the Doherty amplifier of this embodiment has very good linearity compared to the class AB amplifier that is the object of the comparison. Figure 7b is a graph showing the simulated result for a Doherty amplifier with N=2, employing the envelope tracking apparatus 200. This graph shows that the Doherty amplifier of this embodiment has a much higher efficiency characteristic compared to the class AB amplifier according to output power back-off.

For reference, the vertical axis of Figure 7a indicates power spectral density (PSD) which shows power distribution for each unit frequency. When amplification is performed in an amplifier, energy is obtained from a DC bias and is converted to radio frequency and then amplification is performed. The vertical axis of Figure 7b indicates power added efficiency (PAE), which represents how much of the power provided as a DC bias contributes to the amplification. In Figure 7a, dBm that is the unit of PSD is a power unit that is obtained by converting Watts (more specifically, milli-Watts) using a log scale. It is well-known to those skilled in the art that the conversion formula is $dBm=10\log(Watt/10^{-3})$.

The Doherty amplifier according to the embodiments as described above employs a way-extension method by which N ways (N≥3, N is a natural number) are established, and an envelope tracking method, so that when the Doherty amplifier is applied to the power amplifier of a mobile communications base station or a handset, high efficiency and linearity can be simultaneously achieved and price competitiveness and reliability of an apparatus employing the Doherty amplifier can be improved.

Also, such a microwave Doherty amplifier may extract a predetermined input envelope signal, appropriately shape the signal, and provide the signal to the gate bias of a peak amplifier in order to obtain improved efficiency characteristics in all types of Doherty amplifiers.

Preferred embodiments have been explained above and shown in the drawings. However, the present invention is not restricted to the above-described embodiments and many variations are possible within the scope of the present invention. The scope of the present invention is not limited by the above description.

In this specification, the verb "comprise" has its normal dictionary meaning, to denote non-exclusive inclusion. That is, use of the word "comprise" (or any of its derivatives) to include one feature or more, does not exclude the possibility of also including further features.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A Doherty amplifier comprising:

   N ways, where N ≥ 3 and N is a natural number;
   a power distribution unit (110) which distributes power to each of the N ways;
   a carrier amplifier (CA) placed on one of the N ways; and
   a respective peak amplifier (PA) placed on each of the remaining (N-1) ways, excluding the way on which the carrier amplifier (CA) is placed:

   **characterised in that** the carrier amplifier (CA) and peak amplifier(s) (PA) are formed using identical transistors and that all of the N ways meet at a common point to which a quarter wave impedance transformer (150) is connected downstream of the N ways.

**2.** A Doherty amplifier according to claim 1, wherein the characteristic impedance ($R_T$) of the quarter wave impedance transformer (150) is:

$$R_T = \sqrt{\frac{R_{OP}R_{OC}}{R_{OP}} R_O}$$

where $R_O$ is an output load resistance at the back of the quarter wave impedance transformer (150), $R_{OC}$ is a characteristic impedance of an offset line at the back of the carrier amplifier (CA) and $R_{OP}$ is a characteristic impedance of an offset line at the back of the or each peak amplifier (PA).

**3.** A Doherty amplifier according to claim 1 or 2, wherein a quarter-wave transmission line (136) is provided at the back of the carrier amplifier (CA), the characteristic impedance of an offset line (132) at the back of the carrier amplifier (CA) has a predetermined angle of $\theta_C$, the characteristic impedance of an offset line (134) at the back of the peak amplifier (PA) has a predetermined angle of $\theta_P$ and a transmission line (122) having a predetermined angle of 90° + $\theta_C$ - $\theta_P$ is placed in front of the or each peak amplifier (PA).

**4.** A Doherty amplifier according to claim 1, 2 or 3, further comprising:

an envelope tracking unit (200) which turns off the peak amplifier (PA) in a low power range and gradually turns on the or each peak amplifier (PA) to the level of the carrier amplifier (CA) bias in a high power range, in order to use the characteristic of the Doherty amplifier which makes the gate bias of the carrier amplifier (CA) different from the gate bias of the or each peak amplifier (PA).

**5.** A Doherty amplifier according to claim 4, wherein the envelope tracking unit comprises:

an envelope detector (210); and
an envelope shaping circuit (220) which attenuates and/or amplifies an envelope signal detected by the envelope detector (210), removes an offset, and provides the signal as a gate voltage of the or each peak amplifier (PA).

**6.** A communications base station comprising a Doherty amplifier according to any of the preceding claims.

**Patentansprüche**

**1.** Doherty-Verstärker mit:

N Wegen, wobei N ≥ 3 ist und N eine natürliche Zahl ist,
einer Leistungsverteilungseinheit (110), welche Leistung auf jeden der N Wege verteilt,
einem Trägerverstärker (CA), der auf einem der N Wege angeordnet ist, und
einem jeweiligen Spitzenverstärker (PA), der, mit Ausnahme des Wegs, auf dem der Trägerverstärker (CA) angeordnet ist, auf jedem der restlichen (N - 1) Wege angeordnet ist,

**dadurch gekennzeichnet, dass**
der Trägerverstärker (CA) und der Spitzenverstärker bzw. die Spitzenverstärker (PA) unter Verwendung identischer Transistoren ausgebildet sind und sich alle N Wege in einem gemeinsamen Punkt treffen, mit dem ein Viertelwellen-Impedanztransformator (150) stromabwärts der N Wege verbunden ist.

**2.** Doherty-Verstärker nach Anspruch 1, wobei die charakteristische Impedanz ($R_T$) des Viertelwellen-Impedanztransformators (150) ist:

$$R_T = \sqrt{\frac{R_{OP}R_{OC}}{R_{OP}} R_O}$$

wobei $R_O$ der Ausgangslastwiderstand auf der Rückseite des Viertelwellen-Impedanztransformators (150) ist, $R_{OC}$ eine charakteristische Impedanz einer Offset-Leitung auf der Rückseite des Trägerverstärkers (CA) ist und $R_{OP}$ eine charakteristische Impedanz einer Offset-Leitung auf der Rückseite des oder jedes Spitzenverstärkers (PA) ist.

3. Doherty-Verstärker nach Anspruch 1 oder 2, wobei eine Viertelwellen-Übertragungsleitung (136) auf der Rückseite des Trägerverstärkers (CA) bereitgestellt ist, wobei die charakteristische Impedanz einer Offset-Leitung (132) auf der Rückseite des Trägerverstärkers (CA) einen vorgegebenen Winkel $\theta_C$ aufweist, die charakteristische Impedanz einer Offset-Leitung (134) auf der Rückseite des Spitzenverstärkers (PA) einen vorgegebenen Winkel $\theta_P$ aufweist und eine Übertragungsleitung (122) mit einem vorgegebenen Winkel $90° + \theta_C - \theta_P$ vor dem oder jedem Spitzenverstärker (PA) angeordnet ist.

4. Doherty-Verstärker nach Anspruch 1, 2 oder 3, welcher weiter aufweist:

eine Einhüllendenverfolgungseinheit (200), welche den Spitzenverstärker (PA) in einem Niederleistungsbereich ausschaltet und den oder jeden Spitzenverstärker (PA) in einem Hochleistungsbereich allmählich bis auf den Pegel der Vorspannung des Trägerverstärkers (CA) einschaltet, um die Kennlinie des Doherty-Verstärkers zu verwenden, welche die Gate-Vorspannung des Trägerverstärkers (CA) von der Gate-Vorspannung des oder jedes Spitzenverstärkers (PA) verschieden macht.

5. Doherty-Verstärker nach Anspruch 4, wobei die Einhüllendenverfolgungseinheit aufweist:

einen Einhüllendendetektor (210) und
eine Einhüllendenformungsschaltung (220), welche ein vom Einhüllendendetektor (210) erfasstes Einhüllendensignal abschwächt und/oder verstärkt, einen Offset entfernt und das Signal als eine Gate-Spannung des oder jedes Spitzenverstärkers (PA) bereitstellt.

6. Kommunikationsbasisstation mit einem Doherty-Verstärker nach einem der vorstehenden Ansprüche.

**Revendications**

1. Amplificateur Doherty comprenant :

N voies, où $N \geq 3$ et N est un nombre entier ;
une unité de distribution de puissance (110) qui distribue de la puissance à chacune des N voies ;
un amplificateur porteur (CA) placé sur l'une des N voies ; et
un amplificateur de pic respectif (PA) placé sur chacune des voies restantes (N-1), excluant la voie sur laquelle l'amplificateur porteur est placé ;

**caractérisé en ce que** l'amplificateur porteur (CA) et les amplificateurs de pic (PA) sont formés en utilisant des transistors identiques et **en ce que** toutes les N voies se rencontrent en un point commun en lequel un transformateur (150) d'impédance de quart d'onde est connecté en aval des N voies.

2. Amplificateur Doherty selon la revendication 1, **caractérisé en ce que** l'impédance caractéristique ($R_T$) du transformateur d'impédance quart d'onde (150) est ;

$$R_T = \sqrt{\frac{R_{OP}R_{OC}}{R_{OP}} R_O}$$

où $R_0$ est une résistance de charge de sortie à la sortie du transformateur (150) d'impédance de quart d'onde, $R_{oc}$ est une impédance caractéristique d'une ligne de décalage à l'arrière de l'amplificateur porteur (CA) et $R_{op}$ est une impédance caractéristique d'une ligne de décalage à l'arrière du ou de chaque amplificateur de pic (PA).

3. Amplificateur Doherty selon la revendication 1 ou 2, **caractérisé en ce qu'**une ligne de transmission (136) de quart d'onde est prévue à l'arrière de l'amplificateur porteur (CA), une impédance caractéristique de la ligne de décalage (132) à l'arrière de l'amplificateur porteur (CA) présente un angle prédéterminé de $\theta_c$, l'impédance caractéristique de la ligne de décalage (134) à l'arrière de l'amplificateur de pic (PA) présente un angle prédéterminé de $\theta_p$ et une ligne de transmission (122) ayant un angle prédéterminé de $90° + \theta_c - \theta_p$ est placé devant le ou chaque amplificateur de pic (PA).

4. Amplificateur Doherty selon la revendication 1, 2 ou 3, **caractérisé en ce qu'**il comporte en outre :

une unité de suivi d'enveloppe (200) qui coupe l'amplificateur de pic (PA) dans une gamme de faible puissance et graduellement met en service le ou chaque amplificateur de pic (PA) au niveau de l'amplificateur porteur (CA) polarisation, dans une gamme de puissance élevée, afin d'utiliser la caractéristique et l'amplificateur Doherty qui rend la polarisation de porte de l'amplificateur porteur (CA) différente de la polarisation de porte du ou de chaque amplificateur de pic (PA).

5. Amplificateur Doherty selon la revendication 4, **caractérisé en ce que** l'unité de suivi d'enveloppe comporte :

un détecteur d'enveloppe (210) ; et
un circuit de formatage d'enveloppe (220) qui atténue ou amplifie un signal d'enveloppe détecté par le détecteur d'enveloppe (210), supprime un décalage, et fournit le signal en tant que tension de porte à, ou à chaque, amplificateur de pic (PA).

6. Station de base de communication comprenant un amplificateur Doherty selon l'une des revendications précédentes.

# FIG. 1

# FIG. 2

# FIG. 3

# FIG. 4

# FIG. 5

GATE BIAS VOLTAGE
($V_{GG, CARRIER}$)

CARRIER
AMPLIFIER
(CA)

230

240

200

INPUT
DOHERTY
NETWORK

OUTPUT
DOHERTY
NETWORK

DELAY LINE

INPUT

PEAKING
AMPLIFIER
(PA)

OUTPUT

210

ENVELOPE
DETECTOR

ENVELOPE
SHAPING
CIRCUIT

220

GATE BIAS VOLTAGE
($V_{GG, PEAKING}$)

# FIG. 6A

ENVELOPE SIGNAL
($V_{ENVELOPE}$)

OP AMP

OP AMP

PEAKING AMPLIFIER
GATE BIAS VOLTAGE
($V_{GG, PEAKING}$)

OFFSET
VOLTAGE
($V_{OFFSET}$)

# FIG. 6B

PEAKING AMPLIFIER
GATE BIAS VOLTAGE

$(V_{GG, PEAKING})$

D

C

ENVELOPE
VOLTAGE

$(V_{ENV})$

B          A

# FIG. 7A

POWER SPECTRAL DENSITY (PSD)
PSD (dBm, 10 dB/div.)

3-WAY, 30dBm

CLASS AB AMPLIFIER

DOHERTY AMPLIFIER

2.134    2.136    2.138    2.140    2.142    2.142    2.146

FREQUENCY (GHZ)

# FIG. 7B